(19) Europäisches Patentamt / European Patent Office / Office européen des brevets

(11) **EP 4 089 912 B1**

(12) **FASCICULE DE BREVET EUROPEEN**

(45) Date de publication et mention de la délivrance du brevet:
**29.11.2023 Bulletin 2023/48**

(21) Numéro de dépôt: **22173122.7**

(22) Date de dépôt: **12.05.2022**

(51) Classification Internationale des Brevets (IPC):
**H02S 20/21** (2014.01)    **H02S 40/42** (2014.01)
**H02S 40/44** (2014.01)    **H01L 31/048** (2014.01)

(52) Classification Coopérative des Brevets (CPC):
**H02S 20/21; H01L 31/048; H02S 40/425;**
**H02S 40/44;** Y02B 10/20

(54) **SYSTÈME HYBRIDE POUR CHAUSSÉE SOLAIRE**

HYBRIDSYSTEM FÜR EINE SOLARBETRIEBENE FAHRBAHN

HYBRID SYSTEM FOR A SOLAR-POWERED ROADWAY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.05.2021 FR 2105059**

(43) Date de publication de la demande:
**16.11.2022 Bulletin 2022/46**

(73) Titulaire: **Université Gustave Eiffel**
**77420 Champs-sur-Marne (FR)**

(72) Inventeurs:
• **Chailleux, Emmanuel**
**44100 Nantes (FR)**
• **Gennesseaux, Eric**
**44200 Nantes (FR)**
• **Vizzari, Domenico**
**44230 Saint Sebastien sur Loire (FR)**
• **Hautière, Nicolas**
**44344 Bouguenais Cedex (FR)**
• **Dumoulin, Jean**
**44344 Bouguenais Cedex (FR)**
• **Sedran, Thierry**
**44344 Bouguenais Cedex (FR)**
• **Bouron, Stéphane**
**44340 Bouguenais (FR)**
• **Lavaud, Stéphane**
**44680 Sainte Pazanne (FR)**
• **Manceau, Jean-Luc**
**44340 Bouguenais (FR)**
• **Piau, Jean-Michel**
**44000 Nantes (FR)**
• **Le Touz, Nicolas**
**46500 Gramat (FR)**

(74) Mandataire: **A.P.I. Conseil**
**Immeuble Newton**
**4, rue Jules Ferry**
**64000 Pau (FR)**

(56) Documents cités:
**WO-A1-2014/125415    US-A1- 2019 181 802**

• **XIANG BO ET AL: "Thermal and electrical performance of a novel photovoltaic-thermal road", SOLAR ENERGY, ELSEVIER, AMSTERDAM, NL, vol. 199, 9 février 2020 (2020-02-09), pages 1-18, XP086116146, ISSN: 0038-092X, DOI: 10.1016/J.SOLENER.2020.02.021 [extrait le 2020-02-09]**

**Description**

**DOMAINE DE L'INVENTION**

La présente invention concerne un système hybride pour chaussée solaire servant à la récupération d'énergie et à l'échange de chaleur.

**ETAT DE LA TECHNIQUE**

La collecte d'énergie est un processus par lequel l'énergie est capturée et stockée en exploitant une source externe (par exemple, l'énergie solaire, l'énergie thermique, l'énergie éolienne, l'énergie électromagnétique ambiante, l'énergie cinétique, etc.).

Le rayonnement solaire peut être directement converti en électricité grâce à des cellules solaires placées sous une couche semi-transparente (route photovoltaïque), ou en chaleur absorbée au moyen d'un liquide caloporteur (systèmes solaires thermiques).

Les systèmes solaires thermiques sont capables de collecter et/ou de concentrer le rayonnement solaire au moyen d'eau ou de sels fondus. Par exemple, ils sont utilisés comme chauffage solaire actif pour un usage personnel ou mis en oeuvre dans des centrales thermiques, où la vapeur, obtenue par l'eau, est utilisée pour activer des turbines.

Pour ce qui concerne la partie thermique, actuellement, la méthode traditionnelle consiste en un réseau de tuyaux encastrés dans le matériau de chaussée, dans lequel l'eau circulant dans les tuyaux est capable d'extraire de l'énergie thermique, en raison du gradient de température entre le fluide et le matériau de chaussée.

En 1979, l'inventeur Wendel a développé le premier brevet (US 4132074, déposé le 2 Janvier 1979) d'échangeur de chaleur pour exploiter le revêtement routier. Le système consiste en un réseau de tuyaux intégré dans l'enrobé bitumineux. Un liquide caloporteur circule dans les tuyaux afin d'extraire la chaleur emmagasinée par la route. En 2002, Hines et Tinari dans le brevet WO0210654, proposent un échangeur de chaleur à appliquer dans les parkings avec une couche superficielle d'enrobé bitumineux. L'innovation par rapport à l'étude précédente est la présence d'une pompe et d'un échangeur de chaleur capable de produire de l'électricité.

En 2005, le brevet US20050199282 propose une route photovoltaïque. Le système est composé d'une couche transparente, d'une couche de panneaux solaires et d'un dispositif permettant l'extraction de la puissance électrique produite. Dans ce brevet, la route est un système modulaire et chaque élément est connecté l'un à l'autre.

Il est connu aussi de l'état de l'art, la demande de brevet WO2014125415 qui présente une cellule photovoltaïque couverte d'un revêtement translucide, avec une profondeur moyenne de texture mesurée comprise entre 0,2 mm et 3 mm, avec une texture irrégulière semblable à l'enduit superficiel.

Dans un article *« Innovative pavement design: Are solar roads feasible »*, Northmore et Tighe ont proposé une structure composée de deux panneaux de verre trempé de 10 mm d'épaisseur pour la couche transparente, de panneaux de 12,7 mm et 19,1 mm d'épaisseur en fibre de verre polyester GPO-3 (un stratifié de fibre de verre constitué de résine polyester renforcée par un mat de fibre de verre) pour la couche électrique et la couche de base respectivement. En termes de performances mécaniques, la route photovoltaïque a pu supporter une contrainte de 16,6 MPa, qui était la limite d'endurance de la feuille de fibre de verre. Dans l'article "Thermal and electrical performance of a novel photovoltaic-thermal road", XIANG BO ET AL., SOLAR ENERGY, ELSEVIER, AMSTERDAM, NL, vol. 199, 9 février 2020 (2020-02-09), pages 1-18, il est décrit un système hybride pour chaussée solaire, dans lequel le système hybride présente une structure sandwich multicouche avec des panneaux solaires et un échangeur de chaleur. La structure sandwich multicouche est formée d'un empilement horizontal de couches ayant une première partie apte à assurer une tenue et un support mécanique du système hybride, une deuxième partie comportant une couche de béton intégrant un réseau de tuyaux dans lesquels circule un liquide caloporteur capable notamment de récupérer de l'énergie thermique de la chaussée par transfert de chaleur et de réguler la température des panneaux solaires en appui sur la première partie, et une troisième partie comportant les panneaux solaires en appui sur la couche de béton ainsi qu'une couche de surface semi-transparente en appui sur les panneaux solaires. La deuxième partie et la troisième partie forment l'échangeur de chaleur, la troisième partie emmagasinant la chaleur qui est échangée avec le liquide caloporteur circulant uniquement dans la deuxième partie.

Les systèmes présentés sont très coûteux et ne présentent pas des performances énergétiques suffisantes

**EXPOSE DE L'INVENTION**

Un but de l'invention est d'utiliser les chaussées pour récupérer l'énergie solaire sous forme électrique et thermique au travers d'un système hybride capable de résister au trafic subi par la dite chaussée.

L'invention présente un système hybride pour chaussée solaire, dans lequel le système hybride présente une structure sandwich multicouche avec des panneaux solaires et un échangeur de chaleur.

La structure sandwich multicouche est formée d'un empilement horizontal de couches ayant :

> une première partie dite « peau inférieure » étanche, apte à assurer une tenue et un support mécanique du système ;

> une deuxième partie dite « âme » constituée d'une couche de béton drainant, permettant la circulation d'un liquide caloporteur capable notamment de récupérer de l'énergie thermique de la chaussée par transfert de chaleur, et de réguler la température de panneaux solaires, en appui sur la première partie ;

> une troisième partie dite « peau supérieure » constituée :

- d'une couche intermédiaire de mortier d'interface, en appui sur la couche de béton drainant ;
- d'une couche électrique composée des panneaux solaires pour générer de l'électricité, en appui sur la couche intermédiaire de mortier d'interface ;
- d'une couche de surface semi-transparente constituée de granulats de verres et d'une colle transparente jouant le rôle de liant, en appui sur la couche électrique ; la couche de surface semi-transparente ayant une résistance à la contrainte en compression supérieure ou égale à 1 MPa.

La deuxième partie et la troisième partie formant l'échangeur de chaleur, la troisième partie emmagasinant la chaleur qui est échangée avec le liquide caloporteur circulant uniquement dans la deuxième partie.

L'invention concerne aussi un ensemble comprenant plusieurs systèmes hybrides présentés précédemment, avec des moyens de circulation du liquide caloporteur entre les deuxièmes parties des systèmes hybrides, et des moyens de récupération de l'énergie électrique, connectés aux panneaux solaires.

Préférablement, les systèmes hybrides sont réalisés sous forme de modules qui présentent des formes leur permettant de paver l'espace, par exemple en s'emboîtant les uns dans les autres.

## DESCRIPTION DES FIGURES

D'autres objectifs, caractéristiques et avantages sortiront de la description détaillée qui suit en référence aux dessins donnés à titre illustratif et non limitatif parmi lesquels :

la figure 1 représente un schéma du système hybride pour chaussée solaire selon un mode de réalisation possible ;

la figure 2 représente une photo d'une vue en coupe du système hybride réalisé ;

la figure 3 représente une vue en coupe verticale du système hybride pour chaussée solaire avec l'épaisseur de chaque couche selon un mode de réalisation ;

la figure 4 représente une vue en coupe verticale de l'ensemble comprenant plusieurs systèmes pour chaussée solaire, l'ensemble suit la structure CUD (chaussées urbaines démontables) selon un mode de réalisation de l'invention ;

la figure 5 représente un système possible pour chaussée solaire sous forme de dalle de CUD selon un mode de réalisation de l'invention ;

la figure 6 ainsi que la figure 7 représentent deux photos de l'utilisation d'un ensemble possible de CUD pour le système hybride de chaussée solaire ;

la figure 8 représente une photo d'un prototype du système hybride pour chaussée solaire selon un mode de réalisation de l'invention dans un châssis pour tester la capacité de stockage d'énergie thermique grâce au liquide caloporteur ;

la figure 9 représente une vue en coupe verticale du système hybride pour chaussée solaire, lié à un réseau de canaux pour la circulation du liquide caloporteur selon un mode de réalisation de l'invention ;

la figure 10 représente une vue en coupe verticale d'un système hybride pour chaussée solaire, avec une couche d'enrobé bitumineux poreux, des panneaux photovoltaïques et une couche de surface semi-transparente, servant de référence ;

la figure 11 représente la disposition de thermocouples pour le prototype du système de référence ;

la figure 12 représente la disposition des thermocouples pour le prototype du système hybride avec le béton comme milieu poreux selon un mode de réalisation de l'invention ;

les figures 13 et 14 représentent la variation de température du système de référence et du prototype du système de l'invention pendant quatre jours, avec des cycles de 24 heures (12 heures de lumière + 12 heures d'absence de lumière) ;

la figure 15 représente une comparaison de la température entre les deux prototypes de systèmes hybrides ;

la figure 16 représente l'énergie stockée dans les prototypes pendant quatre jours, avec des cycles de 24 heures (12 heures de lumière + 12 heures d'absence de lumière).

## DESCRIPTION DETAILLEE DE L'INVENTION

L'invention concerne un système hybride 1 pour chaussée solaire, qui présente une structure sandwich multicouche avec des panneaux solaires 9 et un échangeur de chaleur, la structure sandwich multicouche est formée d'un empilement horizontal de couches.

L'expression « chaussée solaire » désigne toute surface devant supporter un trafic quel qu'il soit, la chaussée pouvant être des routes, des esplanades, des parkings ou des plateformes.

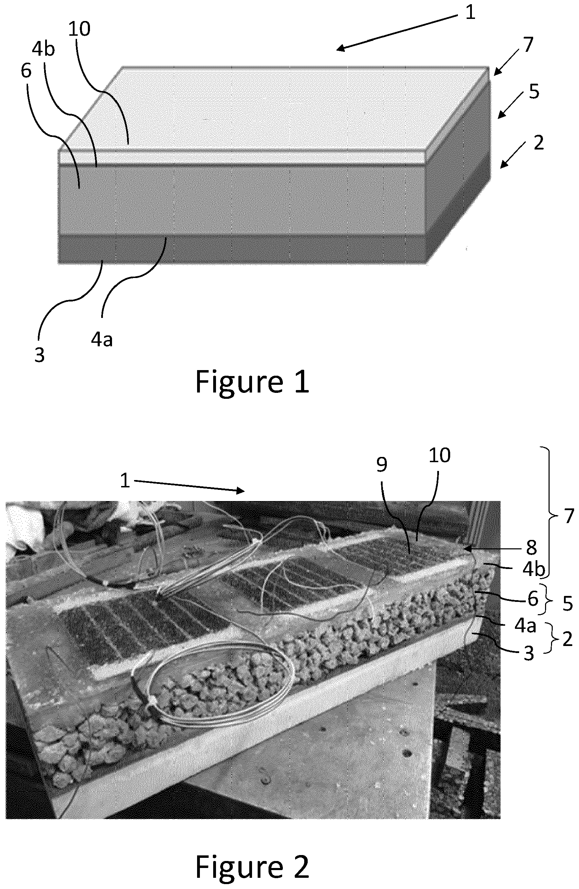

Comme représenté sur l'ensemble des figures 1 à 3, le système hybride 1 présente l'empilement horizontal de couches suivant :

> une première partie 2 dite « peau inférieure » étanche, apte à assurer une tenue et un support mécanique du système hybride 1 ;

> une deuxième partie 5 dite « âme » constituée d'une couche de béton drainant 6, permettant la circulation d'un liquide caloporteur capable notamment de récupérer de l'énergie thermique de la chaussée par transfert de chaleur, et de réguler la température de panneaux solaires 9, en appui sur la première partie 2 ;

> une troisième partie 7 dite « peau supérieure » constituée :

- d'une couche intermédiaire de mortier d'interface 4b, en appui sur la couche de béton drainant 6 ;
- d'une couche électrique 8 composée des panneaux solaires 9 pour générer de l'électricité, en appui sur la couche intermédiaire de mortier d'interface 4b;
- d'une couche de surface semi-transparente 10 constituée de granulats de verres et d'une colle transparente jouant le rôle de liant (pour l'adhérence de la couche), en appui sur la couche électrique 8 ;
  la couche de surface semi-transparente 10 ayant une résistante à la compression supérieure ou égale à 1MPa (la couche de surface semi-transparente 10 présente une résistance pouvant supporter la contrainte mécanique maximale générée par un camion sur une chaussée).

La deuxième partie 5 et la troisième partie 7 forment l'échangeur de chaleur : la troisième partie 7 emmagasinant la chaleur qui est échangée avec le liquide caloporteur circulant uniquement dans la deuxième partie 5. Cet échange se fait notamment par le contact avec la surface du mortier 4b.

La chaussée solaire peut être : un trottoir, une piste cyclable, une rue, une esplanade, une plateforme, une route ou toute autre surface exposée au soleil et accueillant ou non une circulation à la surface.

Avantageusement, le rapport entre épaisseur deuxième partie 5 /épaisseur troisième partie 7 est compris entre 1 et 6.

Avantageusement, la deuxième partie 5 et la troisième partie 7 sont configurées pour augmenter l'efficacité énergétique de l'échangeur de chaleur grâce :

- à un effet de serre lié à la couche de surface semi-transparente 10 (qui emmagasine de l'énergie thermique et ne fait pas barrière thermique comme les enrobés bitumineux utilisés dans l'état de l'art),
- au coefficient de convection entre la couche de béton drainant et le liquide caloporteur, (le coefficient étant plus élevé que celui obtenu avec des enrobés bitumineux et le même liquide caloporteur),
- à la perméabilité de la couche de béton drainant 6 (la perméabilité étant au moins deux fois plus élevée que celle obtenue avec des enrobés bitumineux et le même liquide caloporteur).

Plus précisément, les principales longueurs d'ondes du rayonnement solaire traversent en grande partie la couche semi-transparente et sont donc absorbées plus en profondeur. Cela permet d'augmenter l'énergie stockée par le liquide caloporteur. Le matériau semi-transparent est aussi opaque aux grandes longueurs d'onde. En d'autres termes, la surface est opaque pour le rayonnement ambiant et absorbante pour le rayonnement solaire.

Ainsi, l'invention en permettant le déplacement d'un liquide caloporteur tel de l'eau dans la couche de béton 6 très drainante, juste en dessous d'une couche transparente qui emmagasine l'énergie thermique, présente une très grande efficacité énergétique. Par ailleurs cette couche de béton 6 très drainante évite l'utilisation de tubes comme c'est au contraire le cas dans l'état de l'art.

La première partie qui est sous le composite (béton drainant + mortiers + supérieure) est déterminée pour assurer la tenue mécanique sous trafic de l'ensemble de la chaussée accueillant le système de récupération d'énergie.

Dans une incarnation possible d'innovation, la première partie 2 comporte :

- une couche de base 3, sur laquelle repose

- une couche intermédiaire de mortier d'interface 4a destinée à réaliser l'étanchéité avec la couche de béton drainant 6.

## La couche de base

C'est une couche de base ayant une résistance mécanique suffisante pour supporter les couches supérieures et assurer la tenue mécanique de l'ensemble de la chaussée sous trafic.

La couche de base peut être constituée d'une première couche ou d'un ensemble de couches aptes à assurer une tenue mécanique du système hybride 1.

La couche de base peut être une plateforme préexistante ou une couche de matériau créée pour le système hybride 1.

La couche de base peut être en béton de ciment, ou en béton bitumineux, ou en d'autres matériaux convenant.

Dans ce mode de réalisation, la première partie 2 présente une couche de béton 3 assurant la bonne tenue mécanique du système hybride 1.

La couche de base étanche 3 peut être en béton avec une résistance à la compression à 28 jours ($R_c28$) supérieure à 20 MPa et une résistance à la traction par fendage ($R_{tb}$) supérieure à 2,5 MPa.

Avantageusement, la couche de base en béton 3 est autoplaçante (l'étalement pouvant être supérieur à 40 cm, respectant la norme NF EN 12350-8), afin de faciliter sa mise en oeuvre dans des moules possiblement complexes.

Avantageusement, la couche de base en béton 3 peut être constituée :

- d'une quantité de fines (ciments ; filler ; cendres volantes...) élevée (entre 400 et 600 kg/m$^3$) pour éviter le ressuage ;
- d'une quantité en eau entre 100 et 300 kg/m$^3$, préférablement entre 150 et 250 kg/m$^3$ ;
  afin d'avoir des performances mécaniques permettant de reprendre les efforts générés par le trafic considéré (piétonnier, urbain...).

Le béton autoplaçant de la couche de base 3 peut contenir des superplastifiants et/ou des fibres, afin de supporter le trafic.

Par exemple, la couche de base 3 présente une formulation composée :

- d'une quantité de gravillons d/D avec plusieurs fractions possibles (500 à 1000 kg/m$^3$) ;
- d'une quantité de sables 0/d (500 à 1500 kg/m$^3$) ;
- d'une quantité de ciment avec des fines (200 à 700 kg/m$^3$) ou des additions minérales ;
- d'une quantité d'eau d'ajout (150 à 250 kg/m$^3$) ;
- d'une quantité de superplastifiants au dosage de saturation.

Avantageusement, des bétons plastiques à fluides conventionnels sont utilisés lorsque l'utilisation d'un système de mise en oeuvre par vibration est possible.

## Couche de béton drainant 6

Avantageusement, la perméabilité de la couche de béton drainant 6 est maximisée tout en minimisant le volume de pâte (ciment, fines et eau + adjuvants). Avantageusement, la perméabilité (verticale ou horizontale) de la couche de béton drainant 6 se situe entre 0,5 et 6 cm/s.

Avantageusement, la couche de béton drainant 6 présente une perméabilité (verticale ou horizontale) K supérieure à 2 cm/s, plus avantageusement supérieure à 4cm/s et une résistance à la contrainte en compression pouvant supporter le trafic auquel la chaussée est soumise. Plus précisément, la résistance à la contrainte en compression à 28 jours ($R_c28$) est supérieure à 2 MPa.

La couche de béton drainant 6 peut présenter un pourcentage de vides supérieur à 20%, voire supérieur à 50%.

Avantageusement, le diamètre maximum des granulats présents dans la couche de béton drainant 6, ne dépasse pas 20% de l'épaisseur de la couche de béton drainant 6.

Le béton drainant 6 peut stocker l'énergie apportée par le rayonnement solaire sous forme d'énergie thermique grâce au liquide caloporteur qui le traverse. De plus, le liquide caloporteur agit comme régulateur de température des panneaux solaires, qui voient alors leur rendement s'améliorer.

Afin de maximiser les échanges thermiques, une haute perméabilité du béton drainant peut être utilisée afin d'augmenter l'efficacité du système hybride 1 en termes d'énergie transférée au liquide caloporteur.

Avantageusement, mais de façon non limitative, la couche de béton drainant 6 est constituée :

- d'une quantité de gravillons d/D (1000 à 1500 kg/m$^3$) ; avantageusement entre 1100 et 1300 kg/m$^3$
- d'une quantité de ciments avec fines (200 à 500 kg/m$^3$) ; avantageusement entre 300 et 400 kg/m$^3$

EP 4 089 912 B1

- d'une quantité d'eau d'ajout (50 à 150 kg/m$^3$).

En plus, la couche de béton drainant 6 peut présenter une quantité de superplastifiant qui modifie la résistance mécanique de la couche, la formulation de cette couche nécessitant alors moins d'eau.

Ainsi, l'utilisation d'une haute perméabilité peut être accompagnée de l'utilisation d'un superplastifiant pour garder des propriétés mécaniques suffisamment performantes pour subir le trafic.

Lors de la formulation du béton drainant 6, la démarche suivante peut être appliquée :

- détermination du diamètre maximum de granulats en fonction de l'épaisseur de la couche de béton drainant 6 considérée pour le système hybride 1 (le diamètre maximum ne peut pas dépasser 20% de l'épaisseur de la couche) ;
- maximisation de la perméabilité du béton en minimisant le volume de pâte (ciment, fines et eau + adjuvants) ;
- recherche pour atteindre les paramètres minimaux suivants :

  • perméabilité (verticale ou horizontale) K supérieure à 2 cm/s
  • résistance à la compression à 28 jours : Rc28> 2MPa.

Couche électrique 8 : Panneaux solaires 9

La couche 8 de la troisième partie 7 est une couche dite « électrique » car elle contient des panneaux solaires 9 servant à la génération d'électricité lorsque les panneaux 9 sont illuminés par de la lumière, plus précisément celle du soleil.

Les panneaux solaires 9 peuvent être par exemple des cellules photovoltaïques ou des panneaux photo-piezo-électriques.

Avantageusement, les panneaux solaires 9 sont collées sur le mortier d'interface 4b avec une colle transparente liquide.

Couche de surface semi-transparente 10

La couche de surface semi-transparente 10 peut être un verre trempé, un polymère ou des granulats de verre dont les éléments sont liés entre eux par une résine adaptée à l'usage (par exemple époxy, polyuréthane, etc.).

La couche de surface semi-transparente 10 peut supporter la charge du trafic, la couche permet une conduite sûre grâce à une adhérence adéquate, et permet le passage de la lumière du soleil vers les panneaux solaires 9 et protège le composant électronique.

Préférablement, la colle utilisée possède une bonne résistance au vieillissement.

Avantageusement, la surface semi-transparente participe activement au bon fonctionnement mécanique et thermique du système hybride 1. Par rapport à une couche bitumineuse classique, la couche de l'invention facilite le passage du rayonnement solaire et maximise le transfert de chaleur aux couches inférieures.

La couche de surface semi-transparente 10 assure une bonne résistance mécanique de l'ensemble du système hybride 1 malgré la faible épaisseur grâce aux excellentes propriétés du polyuréthane thermodurcissable (excellente adhérence entre les granulats de verre et le liant, bonne résistance thermique et au vieillissement pour l'exposition aux agents atmosphériques).

La surface semi-transparente peut s'inspirer de la technique d'enduit de surface, constituée d'une couche uniforme de granulats posés sur une fine couche de polyuréthane.

Couches intermédiaires 4a et 4b : Mortier d'interface

Avantageusement, les couches intermédiaires de mortier d'interface 4a et 4b (dans la première partie 2 et la troisième partie 7) permettent de structurer (maintenir) les parties entre elles et de limiter les fuites de liquide caloporteur.

Les mortiers d'interfaces 4a et 4b permettent d'étanchéifier au maximum les parois supérieures et inférieures de la couche de béton drainant afin de limiter les fuites de liquide caloporteur.

Ces couches d'interfaces 4a et 4b ne servent pas de barrière thermique et ne limitent pas les échanges.

Avantageusement, les couches de mortier d'interfaces 4a et 4b peuvent être mises en oeuvre aisément.

Les couches intermédiaires de mortier d'interface 4a et 4b peuvent être un matériau cimentaire ou autre. Par exemple, un matériau à matrice organique, tel qu'un mortier bitumineux, en polyuréthane, élastomères.

Avantageusement, les couches intermédiaires de mortier d'interface 4a et 4b peuvent présenter les constituants suivants :

- granulats conformes à la norme NF EN 12620 relative aux spécifications des granulats pour béton ;

- ciments adaptés aux performances visées et conforme à la norme NF EN 197-1.

Les couches intermédiaires de mortier d'interface 4a et 4b peuvent comporter une quantité de superplastifiant.

Les couches intermédiaires de mortier d'interface 4a et 4b peuvent présenter les caractéristiques suivantes :

- $D_{max}$<4mm ($D_{max}$ étant le diamètre maximal des granulats présents dans cette couche);
- $R_c$28>40 MPa ;
- mise en oeuvre aisée ;
- ne pas incorporer d'entraineur d'air.

Avantageusement, par exemple, le mortier d'interface 4b est un mortier constitué :

- d'une quantité de sables fins ($D_{max}$<4mm) ;
- d'une quantité de ciment ;
- d'une quantité d'eau d'ajout entre 200 et 350 kg/m$^3$ ;

de façon à obtenir une fluidité limitée à l'état frais évitant l'écoulement dans la couche drainante ;
et obtenir des performances mécaniques permettant de reprendre les efforts générés par le trafic considéré (piétonnier, urbain...).

Dans un autre mode de réalisation, le mortier d'interface 4b est à base de bitume.

La fluidité des couches intermédiaires 4a et 4b peut être différente.

Avantageusement, la couche intermédiaire 4a de la première partie 2 du système hybride 1 est un matériau à matrice organique et la couche intermédiaire 4b reposant sur la deuxième partie 5 est un matériau cimentaire.

Le mortier d'interface 4a possède avantageusement moins d'eau que la couche de mortier 4b ; sa viscosité présentant moins de problème que la couche de mortier 4b reposant sur la couche de béton 6, la couche de mortier d'interface 4a reposant sur le support de la première partie.

Liquide caloporteur

Le liquide caloporteur circule dans la couche de béton drainant 6 et ne circule pas dans la couche de base. Le liquide caloporteur permet de récupérer la chaleur du système hybride 1 et de refroidir le système hybride 1. Avantageusement, le liquide caloporteur chauffé est stocké. Dans une incarnation possible, le liquide caloporteur récupère la chaleur du système hybride 1 puis transfère la chaleur collectée à un système annexe (externe).

Préférablement, le liquide caloporteur récupère la chaleur du système hybride 1 et permet de le refroidir, la couche de surface semi-transparente 10 est aussi rafraichie, permettant le refroidissement de la chaussée et de lutter contre les effets d'« îlots de chaleur ».

Avantageusement, le liquide caloporteur sert de régulateur de température. Plus précisément lorsque la température est trop élevée, le liquide caloporteur refroidit le système hybride 1, inversement si le système hybride 1 est trop froid, le liquide caloporteur permet de réchauffer le système hybride 1 (de maintenir la température globale du système hybride 1 à une température de fonctionnement idéale). Avantageusement, le liquide caloporteur permet le dégivrage de la chaussée.

Avantageusement, le liquide caloporteur refroidit les panneaux solaires 9 de la couche électrique 8, permettant de maximiser les productions des panneaux solaires 9.

Avantageusement, le liquide caloporteur peut être de l'eau.

Ensemble 11 de systèmes hybrides 1

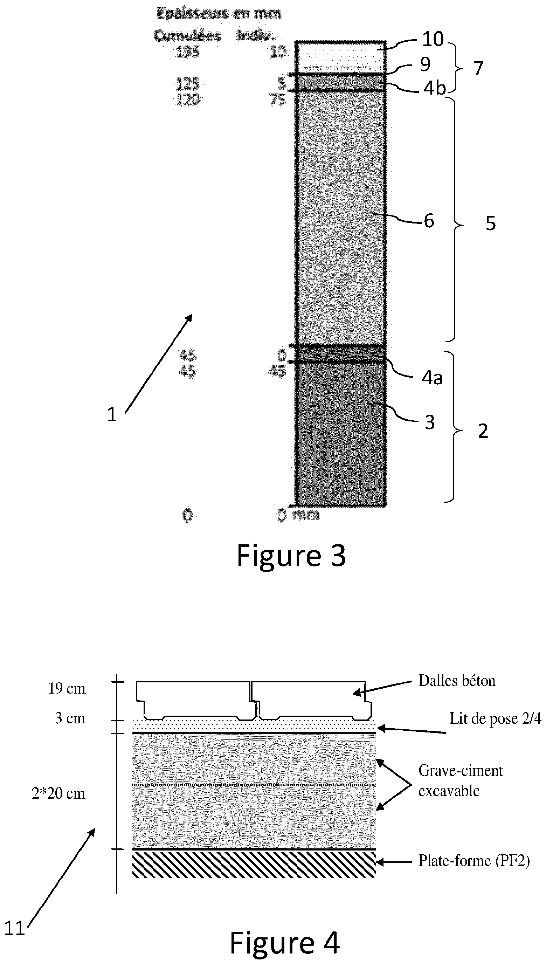

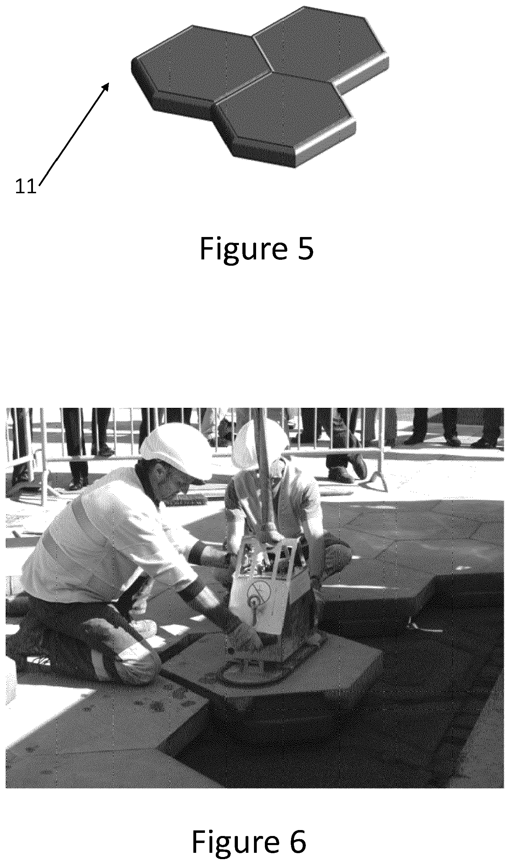

Comme représenté figures 4 à 7, avantageusement, selon un deuxième aspect de l'invention, l'invention concerne un ensemble comprenant plusieurs systèmes hybrides 1 réalisés sous forme de modules permettant de paver l'espace.

Les systèmes hybrides 1 sont réalisés sous forme de modules et peuvent présenter des formes leur permettant de s'emboiter ou s'encastrer les uns dans les autres (solution modulaire CUD [chaussées urbaines démontables] ou assimilé avec un système d'emboitement).

Avantageusement, les systèmes hybrides 1 sont réalisés sous forme de modules interconnectables, les modules peuvent être de forme hexagonale, rectangulaire, triangulaire, etc.

Les systèmes hybrides 1 peuvent être réalisés sous forme de modules interconnectables hydrauliquement et/ou électriquement.

Avantageusement, l'ensemble 11 est connecté :

- électriquement via des moyens de récupération de l'énergie électrique reliés électriquement aux panneaux solaires 9, à un moyen de stockage d'énergie électrique (emmagasiner l'électricité produite par les panneaux solaires 9).
- hydrauliquement via des moyens de circulation du liquide caloporteur reliant les deuxièmes parties de chacun des systèmes hybrides 1, à des moyens de stockage du liquide caloporteur permettant de récupérer l'énergie thermique de ce dernier.

Avantageusement, l'ensemble 11 comprend des moyens de chauffage du liquide caloporteur couplés aux moyens de circulation du liquide caloporteur pour notamment dégivrer la chaussée solaire.
Préférablement, l'ensemble 11 de systèmes hybrides 1 peut permettre de :

- dégivrer la chaussée,
- lutter contre les îlots de chaleur urbains,
- fournir de l'électricité aux appareils locaux, notamment l'éclairage des rues
- réguler la température des bâtiments environnants (chauffer / climatiser).

Procédé de réalisation du système hybride 1

Selon un troisième aspect de l'invention, l'invention concerne un procédé de réalisation du système hybride 1, comprenant les étapes suivantes :

- coulage d'une couche de béton drainant 6 sur la première partie 2,
- coulage d'une couche de mortier d'interface 4b sur la couche de béton drainant 6 durcie,
- collage de la couche électrique 8 avec panneaux solaires 9 sur la couche de mortier durcie 4b,
- réalisation de la couche de surface semi-transparente 10 constituée de granulats de verres et de colle.

Avantageusement, quand la première partie 2 est constituée par une couche de base 3 en béton, le procédé de réalisation du système hybride possède les étapes supplémentaires suivantes :

- coulage de la couche de base en béton étanche 3 et durcissement de la couche de base 3,
- coulage d'une couche de mortier d'interface 4a sur la couche de base en béton 3 durcie,
- coulage de la couche de béton drainant 6 sur la couche de mortier 4a fraichement déposée et non durcie (permettant de bien intégrer la couche de béton drainant 6 au mortier d'interface 4a) puis avantageusement une étape de compactage.

Avantageusement, la couche de mortier d'interface 4b possède une viscosité permettant de ne pas rentrer dans la couche de béton drainant 6 lors du dépôt. Avantageusement, la couche de mortier 4b est aussi suffisamment liquide pour effectuer un dépôt plan.
Un exemple de formule possible, pour respectivement la couche de base 3, les couches intermédiaires 4a et 4b et la couche de béton drainant 6, est présenté dans le tableau 1 ci-dessous :

**Tableau 1**

| B.A.P. 3 | | Mortiers 4a & 4b | | Béton drainant 6 | |
|---|---|---|---|---|---|
| **Constituants** | **Masse** (kg/ m³) | **Constituants** | **Masse** (kg/ m³) | **Constituants** | **Masse** (kg/ m³) |
| Gravillon 6,3/10 | 759 | 0/2 Sable | 1299,5 | Granulats 10/14 | 1269 |
| Sable 0/4 | 898 | Ciment | 650,7 | Ciment | 375 |
| Filler | 200 | Eau d'ajout | 288,8 | Eau d'ajout | 84 |
| Ciment | 298 | | | | |
| Superplastifiant | 3,6 | | | | |
| Eau d'ajout | 185 | | | | |

(suite)

| B.A.P. 3 | | Mortiers 4a & 4b | | Béton drainant 6 | |
|---|---|---|---|---|---|
| Constituants | Masse *(kg/ m³)* | Constituants | Masse *(kg/ m³)* | Constituants | Masse *(kg/ m³)* |
| Résistance Rc (MPa) | 42 | Résistance Rc (MPa) | 53 | Résistance Rc (MPa) | 6,3 |
| Perméabilité (cm/s) | s/o | Perméabilité (cm/s) | s/o | Perméabilité (cm/s) | 5,3 |

Préférablement, la réalisation de la couche électrique 8 et de la couche de surface semi-transparente 10 suit les étapes suivantes :

- coulage d'une épaisseur de colle transparente liquide jouant le rôle de liant, en appui sur la couche de mortier d'interface 4b durcie,
- collage de la couche électrique 8 avec panneaux solaires 9 sur la couche de mortier 4b durcie, par polymérisation de la colle,
- coulage d'une seconde épaisseur de colle transparente liquide, des granulats de verre enchâssés dans la seconde épaisseur,
- compactage de la seconde épaisseur pour obtenir une surface uniforme, sans granulats de verre saillants, et polymérisation de l'ensemble,

pour réaliser la couche de surface semi-transparente 10 constituée de granulats de verres et de colle.

Avantageusement, la colle est une couche de polyuréthane dans laquelle les panneaux solaires 9 sont immergés.

Préférablement, le temps du durcissement des polymérisations des couches de polyuréthane varie en fonction du type de colle et de la température ambiante. Par exemple, à 20 degrés, le temps de durcissement est d'environ 24 heures.

Un exemple de réalisation de la surface semi-transparente 10 est donné dans le tableau 2 ci-dessous :

**Tableau 2**

| Etapes | Description | Commentaires |
|---|---|---|
| 1. | Coulage de la première couche de polyuréthane | La colle doit couvrir la cellule photovoltaïque 9 afin d'obtenir une couche uniforme |
| 2. | Polymérisation de la première couche | Les temps de durcissement dépendent du type de colle et de la température ambiante. Par exemple, à 20 degrés, le temps de durcissement est d'environ 24 heures |
| 3. | Coulage de la couche de béton drainant de polyuréthane | La densité de surface de la colle est 1 kg/m² |
| 4. | déposition des granulats de verre 2/4mm selon la technique de l'enduit superficiel | La densité de surface des granulats 2/4mm est de 2 kg/m² |
| 5. | Léger compactage immédiatement après la pose des granulats | le but est d'obtenir une surface uniforme, sans granulats de verre saillants |
| 6. | Polymérisation de la seconde couche | Voir le commentaire de l'étape 2 |

Énergie stockée

Le système hybride 1 est capable de stocker l'énergie grâce au gradient de température entre le liquide caloporteur et la deuxième partie 5 étant un milieu poreux. Le flux de chaleur est provoqué par la radiation incidente du soleil, par la convection entre le prototype et l'air et par la radiation thermique de la surface. Puis, par conduction, le flux de chaleur est transmis de troisième partie 7 jusqu'à la deuxième partie 5.

Par ailleurs, ce flux de chaleur provoque un changement de température dans le prototype qui mène à un mécanisme de convection de l'interface milieu poreux-liquide. L'énergie stockée par le liquide caloporteur est donnée par la formule suivante :

$$E = \rho_f C_{p,f} Q \cdot \Delta T$$

Avec :

- $\rho_f$ : densité du liquide ($\approx$ 1000 Kg/m$^3$ pour l'eau);
- $C_{p,f}$: capacité thermique isobare massique du liquide ($\approx$4180 J/Kg.K pour l'eau);
- Q : débit du milieu poreux ;
- $\Delta T$ : différence de température du liquide caloporteur entre l'entrée et la sortie du milieu poreux.

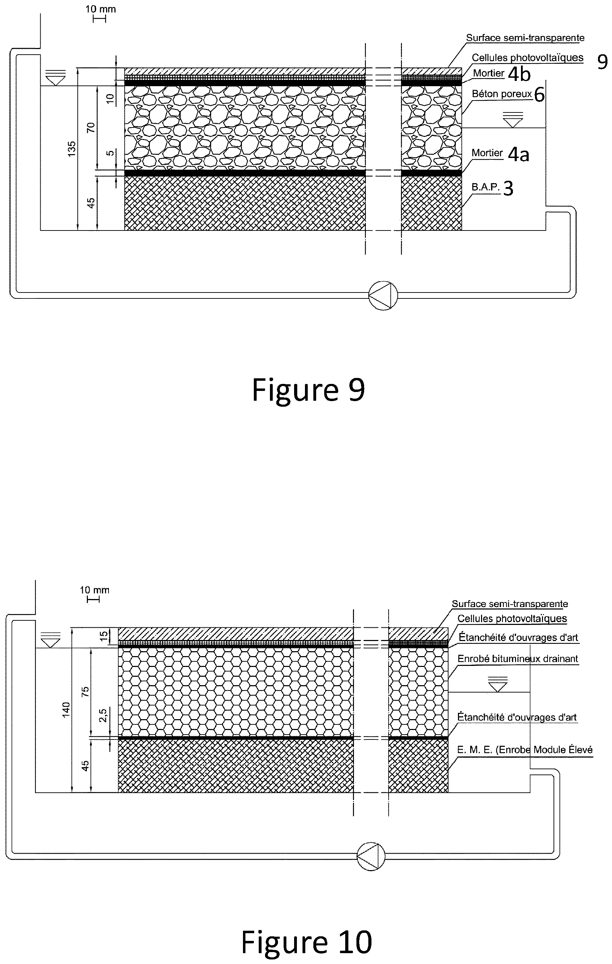

Afin d'évaluer l'efficacité du système hybride 1 de la présente invention deux systèmes prototypes ont été étudiés : un premier système dont le milieu poreux est un enrobé bitumineux (Figure 10) servant de référence, et le deuxième système innovant étant le système hybride 1 (Figure 9) dans lequel le milieu poreux est en béton.

Montage expérimental

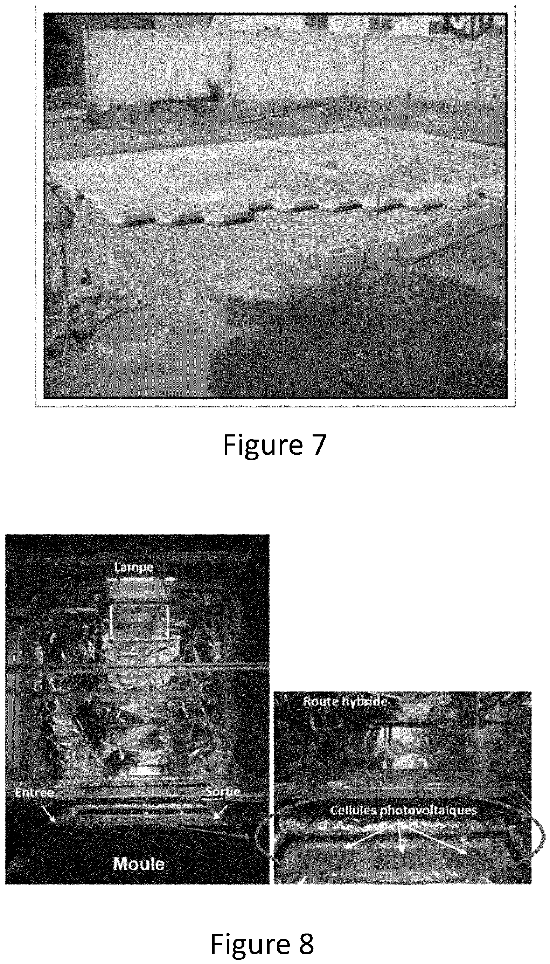

Pour mesurer Q et $\Delta T$, les prototypes sont placés dans un moule étanche avec une pente d'environ 1% et sont exposés à la radiation d'une lampe avec une puissance de 1500 watt (Figure 8). Le moule dispose de deux réservoirs qui correspondent à l'entrée et à la sortie des prototypes. Quand le fluide caloporteur (soit de l'eau avec une température x) traverse le milieu poreux, sa température augmente grâce au mécanisme de convection. À la sortie des prototypes, le fluide caloporteur (l'eau), qui présente alors une température x+$\Delta T$, est canalisée vers un récipient de stockage. Celui-ci est équipé d'un échangeur de chaleur permettant de ramener le fluide caloporteur à la température x. Une pompe réinjecte alors le fluide caloporteur du récipient de stockage à l'entrée du milieu poreux et le cycle recommence.

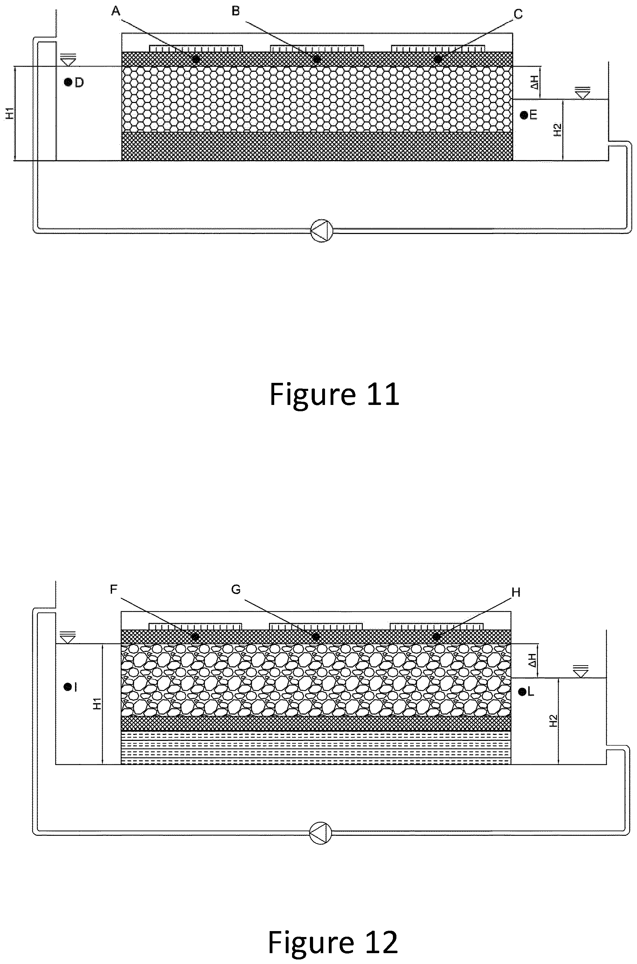

Le cycle est équilibré quand la différence d'altitude $\Delta H$ est constante pendant la durée du cycle. Pour ce faire, le débit est réglé pour avoir la hauteur H1 au même niveau que le milieu poreux (voir Figure 11 et Figure 12).

Pendant le test, les changements de température dans les prototypes sont détectés avec 10 thermocouples (Figure 11 et Figure 12).

Avantageusement, comme illustré dans le tableau 3 ci-dessous, la composition du système de référence est :

Tableau 3

| Enrobé bitumineux drainant | | E.M.E. (Enrobé Module Élevé) | |
|---|---|---|---|
| Constituants | Pourcentage | Constituants | Pourcentage |
| Granulats 10/20 | 0.00 | Granulats 10/20 | 0.00 |
| 10/14 | 82.14 | 10/14 | 0.00 |
| 6/10 | 0.00 | 6/10 | 30.30 |
| 4/6 | 0.00 | 4/6 | 15.15 |
| 2/4 | 0.00 | 2/4 | 18.47 |
| 0/2 | 10.51 | 0/2 | 28.41 |
| Fines | 3.00 | Fines | 2.37 |
| Liant 35/50 | 4.70 | Liant 10/20 | 5.30 |

Résultats

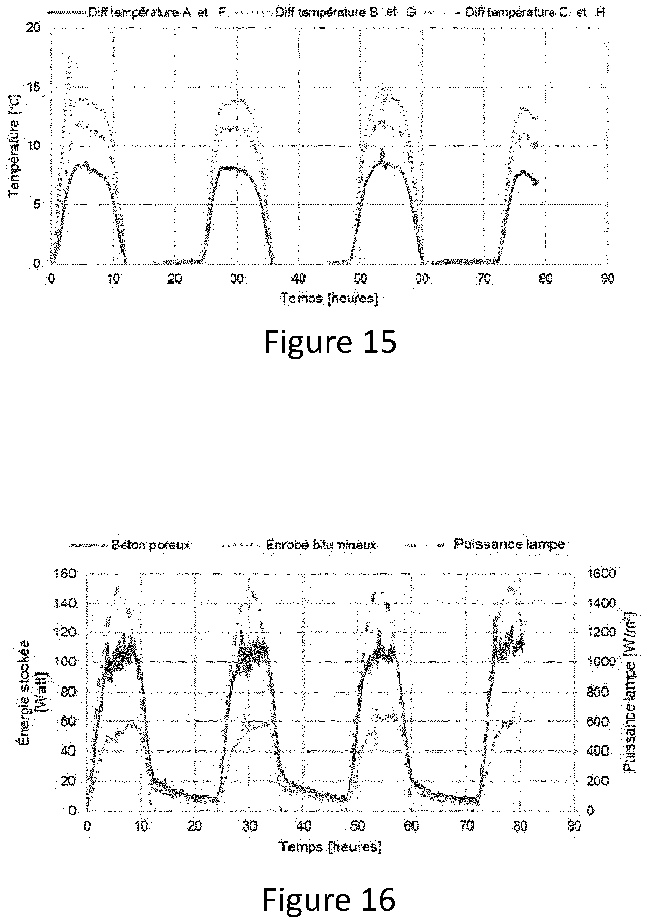

Le test est effectué pendant quatre jours, avec des cycles de 24 heures (12 heures de lumière + 12 heures d'absence de lumière). La puissance de la lumière suit un signal sinusoïdal comme le montre la Figure 16. Le maximum du signal correspond à une radiation d'environ 1500 W/m$^2$.

Sur la base du réglage selon les indications de la Figure 4, le débit est de 0,0335 l/s pour le système hybride 1 avec le béton poreux et de 0,0172 l/s pour la solution en enrobé bitumineux poreux, soit le système de référence.

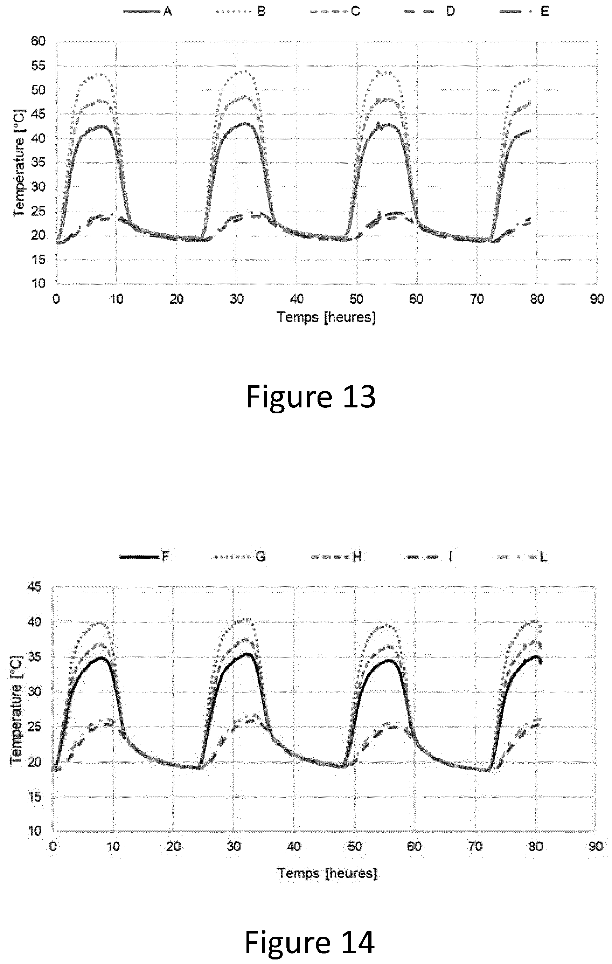

En général, la température est d'autant plus élevée que les thermocouples sont proches de la surface. Les thermocouples B et G mesurent les valeurs les plus hautes, car la lampe est placée au-dessus de leur position (Figure 13 et Figure 14).

En tenant compte de la position des thermocouples, on peut comparer les thermocouples A vs F ; B vs G et C vs H. (Figure 15).

Les résultats montrent que le système hybride 1 (thermocouples F, G et H) atteint des températures plus faibles que dans le système de référence (thermocouples A, B et C) dans les mêmes conditions d'essai. Ce phénomène peut être expliqué par la différence en termes de conductivité, d'albédo et de diffusivité thermique entre le béton et l'enrobé bitumineux.

La conductivité du béton et de l'enrobé bitumineux est respectivement d'environ 2 W/mK et 1 W/mK. Autrement dit, les propriétés isolantes de l'enrobé bitumineux sont meilleures que celles du béton. De plus, le béton présente un albédo de 0,05 contre 0,33 pour l'enrobé bitumineux.

La diffusivité thermique caractérise la vitesse de propagation de chaleur dans un matériau ; elle peut être définie par :

$$\alpha = \frac{k}{\rho \cdot C_p}$$

Avec :

k : conductivité [W/mK]
$\rho$ : densité [kg/m3]
Cp : capacité thermique isobare massique [J/Kg-K]

En considérant :

| | k [W/mK] | $\rho$ [Kg/m$^3$] | Cp [J/Kg·K] | $\alpha$ [mm$^2$/s] |
|---|---|---|---|---|
| Enrobé bitumineux | 0.55 | 2200 | 900 | 0.28 |
| Béton | 1.13 | 2400 | 1000 | 0.47 |

Le tableau montre que le béton a une diffusivité thermique presque 2 fois plus élevée que celle de l'enrobé bitumineux. En d'autres termes, le béton est un meilleur diffuseur de chaleur.

En conclusion, cette expérimentation montre que l'énergie collectée par le système hybride 1 objet du présent brevet est deux fois supérieure à celle collectée par le système de référence à base d'enrobé bitumineux.

Pour une analyse quantitative, on peut regarder l'énergie dans un intervalle de temps de six heures. Le centre de cet intervalle correspond au maximum du signal sinusoïdal de la lampe. Les valeurs moyennes d'énergie stockée sont de 103,1 Watt pour le système hybride 1 et de 54,4 Watt pour le système en enrobé bitumineux (Figure 16). Ce résultat confirme la pertinence du système hybride 1 objet du présent brevet.

Avantages

Dans le système hybride 1, la récupération d'énergie photovoltaïque est associée à la récupération d'énergie thermique (système hybride) et possède les avantages suivants :

- échangeur poreux optimisé ;
- formulation d'un béton de ciment drainant 6 aux propriétés optimisées en remplacement des enrobés bitumineux poreux :

  - perméabilité améliorée ;
  - maintien de la porosité au cours du temps ;
  - formulation d'un mortier d'étanchéité ;
  - performances mécaniques améliorées (par exemple, la résistance à la compression est supérieure à 40 MPa) ;
  - échangeur de chaleur : un seul matériau homogène ;

- dans une incarnation possible, l'ensemble 11, comprenant des systèmes hybrides 1 pour chaussée solaire, est modulaire pour faciliter la maintenance, et par exemple, l'ensemble est formé de dalles préfabriquées en matériau cimentaire.

Avantageusement, la perméabilité améliorée est égale ou supérieure à 4 cm/s.

La combinaison de l'excellente résistance de la couche semi-transparente 10 et de la base en béton 3 participe à la tenue mécanique du système hybride 1 dans son intégralité.

En termes de performances mécaniques, une charge statique a été appliquée sur un échantillon composé de la couche semi-transparente 10 (la couche de l'invention) collée sur une dalle de béton de 7 cm d'épaisseur. La zone de charge avait un diamètre de 44 mm. La force de charge a été transmise à la surface de l'échantillon via une interface en caoutchouc dur extrait des pneus utilisés. L'échantillon a résisté à 9500N, ce qui équivaut à 6,25 MPa de contrainte de compression. Considérant que la contrainte maximale d'un camion lourd sur une chaussée est d'environ 1 MPa, le système 1 supporte le trafic lourd.

**Revendications**

1. Système hybride (1) pour chaussée solaire, dans lequel le système hybride (1) présente une structure sandwich multicouche avec des panneaux solaires (9) et un échangeur de chaleur, la structure sandwich multicouche étant formée d'un empilement horizontal de couches ayant :

   > une première partie (2) dite « peau inférieure » étanche, apte à assurer une tenue et un support mécanique du système hybride (1) ;
   > une deuxième partie (5) dite « âme » comportant une couche de béton drainant (6), permettant la circulation d'un liquide caloporteur capable notamment de récupérer de l'énergie thermique de la chaussée par transfert de chaleur, et de réguler la température des panneaux solaires (9), en appui sur la première partie (2);
   > une troisième partie (7) dite « peau supérieure » comportant :

   - d'une couche intermédiaire de mortier d'interface (4b), en appui sur la couche de béton drainant (6) ;
   - d'une couche électrique (8) composée des panneaux solaires (9) pour générer de l'électricité, en appui sur la couche intermédiaire de mortier d'interface (4b) ;
   - d'une couche de surface semi-transparente (10) comportant des granulats de verre et d'une colle transparente jouant le rôle de liant, en appui sur la couche électrique (8) ; la couche de surface semi-transparente (10) ayant une résistance à la contrainte en compression supérieure ou égale à 1MPa,

   la deuxième partie (5) et la troisième partie (7) formant l'échangeur de chaleur, la troisième partie (7) emmagasinant la chaleur qui est échangée avec le liquide caloporteur circulant uniquement dans la deuxième partie (5).

2. Système hybride (1) selon la revendication 1, dans lequel la deuxième partie (5) et la troisième partie (7) sont configurées pour augmenter l'efficacité énergétique de l'échangeur de chaleur par :

   - un effet de serre lié à la couche de surface semi-transparente (10), et
   - le coefficient de convection entre la couche de béton drainant (6) et le liquide caloporteur, et
   - la perméabilité de la couche de béton drainant (6).

3. Système hybride (1) selon l'une des revendications précédentes, dans lequel la couche de béton drainant (6) présente une perméabilité K supérieure à 2 cm/s et une résistance à la contrainte en compression à 28 jours $R_c28$ supérieure à 2 MPa.

4. Système hybride (1) selon l'une des revendications précédentes, dans lequel la couche de béton drainant (6) présente une perméabilité K supérieure à 4 cm/s et une résistance à la contrainte en compression à 28 jours $R_c28$ supérieure à 2 MPa.

5. Système hybride (1) selon l'une des revendications précédentes, dans lequel dans la couche de béton drainant (6), le diamètre maximum de granulats ne dépasse pas 20% de l'épaisseur de la couche de béton drainant (6).

6. Système hybride (1) selon l'une des revendications précédentes, dans lequel la couche de béton drainant (6) est constituée :

   - d'une quantité de gravillons d/D entre 1000 à 1500 kg/m$^3$ ; avantageusement entre 1100 et 1300 kg/m$^3$ ;
   - d'une quantité de ciments avec fines, entre 200 à 500 kg/m$^3$ ; avantageusement entre 300 et 400 kg /m$^3$ ;
   - d'une quantité d'eau d'ajout entre 50 à 150 kg/m$^3$.

**7.** Système hybride (1) selon l'une des revendications précédentes, dans lequel la couche de béton drainant (6) présente des superplastifiants.

**8.** Système hybride (1) selon l'une des revendications précédentes, dans lequel la couche intermédiaire de mortier d'interface (4b) est un matériau cimentaire.

**9.** Système hybride (1) selon la revendication précédente, dans lequel la couche intermédiaire de mortier d'interface (4b) présente les caractéristiques suivantes :

-

$$D_{max}<4mm$$

-

$$R_c28>40 \text{ MPa.}$$

**10.** Système hybride (1) selon l'une des revendications précédentes, dans lequel la première partie (2) comporte une couche de base en béton (3), sur laquelle repose une couche intermédiaire de mortier d'interface (4a) destinée à réaliser l'étanchéité avec la couche de béton drainant (6).

**11.** Système hybride (1) selon la revendication précédente, dans lequel la couche de base en béton (3) présente une résistance à la compression à 28 jours $R_c28$ supérieure à 20 MPa et une résistance à la traction par fendage $R_{tb}$ supérieure à 2,5 MPa.

**12.** Système hybride (1) selon l'une des revendications précédentes 10 ou 11, dans lequel la couche de base en béton (3) est autoplaçante.

**13.** Système hybride (1) selon l'une des revendications précédentes, dans lequel le mortier d'interface (4b) de la troisième partie (7) est un mortier comportant notamment :

- d'une quantité de sable fin ;
- d'une quantité de ciment ;
- d'une quantité d'eau d'ajout en 200 et 350 kg/m$^3$,
de façon à présenter une fluidité limitée à l'état frais évitant l'écoulement dans la couche de béton drainant (6), et des performances mécaniques permettant de reprendre les efforts générés par le trafic considéré.

**14.** Système hybride (1) selon l'une des revendications précédentes, dans lequel le liquide caloporteur est de l'eau.

**15.** Ensemble (11) comprenant :

- plusieurs systèmes hybrides (1) selon l'une des revendications 1 à 14,
- des moyens de circulation du liquide caloporteur dans les deuxièmes parties des systèmes hybrides (1),
- des moyens de stockage de l'énergie thermique couplés aux moyens de circulation,
- des moyens de récupération de l'énergie électrique, connectés aux panneaux solaires.

**16.** Ensemble (11) selon la revendication 15, dans lequel l'ensemble (11) comprend des moyens de chauffage du liquide caloporteur couplés aux moyens de circulation du liquide caloporteur pour notamment dégivrer la chaussée solaire.

**17.** Ensemble (11) selon la revendication 15, dans lequel les systèmes hybrides (1) sont réalisés sous forme de modules permettant de paver l'espace.

**18.** Ensemble (11) selon la revendication 17, dans lequel les systèmes hybrides (1) sont réalisés sous forme de modules interconnectables hydrauliquement et/ou électriquement.

**19.** Procédé de réalisation du système hybride (1) défini selon l'une des revendications 1 à 14, comprenant les étapes suivantes :

- coulage d'une couche de béton drainant (6) sur la première partie (2),
- coulage d'une couche de mortier d'interface (4b) sur la couche de béton drainant (6) durcie,
- collage de la couche électrique (8) avec panneaux solaires (9) sur la couche de mortier (4b), et
- réalisation de la couche de surface semi-transparente (10) constituée de granulats de verres et de colle.

20. Procédé selon la revendication 19, dans lequel la réalisation de la couche électrique (8) et de la couche de surface semi-transparente (10) suit les étapes suivantes :

- coulage d'une épaisseur de colle transparente liquide jouant le rôle de liant, en appui sur la couche de mortier d'interface (4b) durcie,
- collage de la couche électrique (8) avec panneaux solaires (9) sur la couche de mortier (4b) durcie, par polymérisation de la colle,
- coulage d'une seconde épaisseur de colle transparente liquide, et pose des granulats de verre enchâssés dans la seconde épaisseur, et
- polymérisation de l'ensemble,

pour réaliser la couche de surface semi-transparente (10) constituée de granulats de verres et de colle.

**Patentansprüche**

1. Hybridsystem (1) für Solarfahrbahn, wobei das Hybridsystem (1) eine mehrschichtige Sandwichstruktur mit Solarpaneelen (9) und einem Wärmetauscher aufweist, wobei die mehrschichtige Sandwichstruktur aus einer horizontalen Stapelung von Schichten gebildet wird, die Folgendes aufweist:

> einen "untere Haut" genannten dichten ersten Teil (2), der imstande ist, für einen Halt und eine mechanische Stütze des Hybridsystems (1) zu sorgen;
> einen "Kern" genannten zweiten Teil (5), der eine Schicht aus Drainagebeton (6) beinhaltet, welcher die Zirkulation einer Wärmeträgerflüssigkeit erlaubt, die insbesondere in der Lage ist, Wärmeenergie von der Fahrbahn durch Wärmeübergang aufzunehmen, und die Temperatur der Solarpaneele (9), die am ersten Teil (2) anliegen, zu regeln;
> einen "obere Haut" genannten dritten Teil (7), der das Folgende beinhaltet:

- eine Zwischenschicht aus Schnittstellenmörtel (4b), die an der Schicht aus Drainagebeton (6) anliegt;
- eine elektrische Schicht (8), die sich aus den Solarpaneelen (9) zusammensetzt, um Elektrizität zu erzeugen, die an der Zwischenschicht aus Schnittstellenmörtel (4b) anliegt;
- eine halbtransparente Oberflächenschicht (10), die Granulate aus Glas und einem transparenten Kleber beinhaltet, der die Aufgabe eines Bindemittels übernimmt, die an der elektrischen Schicht (8) anliegt; wobei die halbtransparente Oberflächenschicht (10) eine Beständigkeit gegenüber Druckbeanspruchung gleich 1 MPa oder mehr aufweist,

> wobei der zweite Teil (5) und der dritte Teil (7) den Wärmetauscher bilden, wobei der dritte Teil (7) die Wärme, die mit der Wärmeträgerflüssigkeit, die nur in dem zweiten Teil (5) zirkuliert, ausgetauscht wird, speichert.

2. Hybridsystem (1) nach Anspruch 1, wobei der zweite Teil (5) und der dritte Teil (7) konfiguriert sind, um die energetische Effizienz des Wärmetauschers zu erhöhen, durch:

- einen Treibhauseffekt in Verbindung mit der halbtransparenten Oberflächenschicht (10), und
- den Konvektionskoeffizienten zwischen der Schicht aus Drainagebeton (6) und der Wärmeträgerflüssigkeit, und
- die Durchlässigkeit der Schicht aus Drainagebeton (6).

3. Hybridsystem (1) nach einem der vorstehenden Ansprüche, wobei die Schicht aus Drainagebeton (6) eine Durchlässigkeit K von mehr als 2 cm/s und eine Beständigkeit gegenüber Druckbeanspruchung in 28 Tagen $R_c28$ von mehr als 2 MPa aufweist.

4. Hybridsystem (1) nach einem der vorstehenden Ansprüche, wobei die Schicht aus Drainagebeton (6) eine Durchlässigkeit K von mehr als 4 cm/s und eine Beständigkeit gegenüber Druckbeanspruchung in 28 Tagen $R_c28$ von mehr als 2 MPa aufweist.

5.  Hybridsystem (1) nach einem der vorstehenden Ansprüche, wobei in der Schicht aus Drainagebeton (6) der maximale Durchmesser von Granulaten 20% der Dicke der Schicht aus Drainagebeton (6) nicht übersteigt.

6.  Hybridsystem (1) nach einem der vorstehenden Ansprüche, wobei sich die Schicht aus Drainagebeton (6) zusammensetzt aus:

    - einer Menge an Splitt d/D zwischen 1000 und 1500 kg/m$^3$; vorteilhafterweise zwischen 1100 und 1300 kg/m$^3$;
    - einer Menge an Zement mit Feinstoffen zwischen 200 und 500 kg/m$^3$; vorteilhafterweise zwischen 300 und 400 kg/m$^3$;
    - einer Menge an Zusatzwasser zwischen 50 und 150 kg/m$^3$.

7.  Hybridsystem (1) nach einem der vorstehenden Ansprüche, wobei die Schicht aus Drainagebeton (6) Betonverflüssiger aufweist.

8.  Hybridsystem (1) nach einem der vorstehenden Ansprüche, wobei die Zwischenschicht aus Schnittstellenmörtel (4b) ein zementartiger Werkstoff ist.

9.  Hybridsystem (1) nach dem vorstehenden Anspruch, wobei die Zwischenschicht aus Schnittstellenmörtel (4b) die folgenden Eigenschaften aufweist:

$$D_{max} < 4 \text{ mm}$$

$$R_c28 > 40 \text{ MPa.}$$

10. Hybridsystem (1) nach einem der vorstehenden Ansprüche, wobei der erste Teil (2) eine Grundschicht aus Beton (3) beinhaltet, auf der eine Zwischenschicht aus Schnittstellenmörtel (4a) aufliegt, die dazu bestimmt ist, für die Abdichtung mit der Schicht aus Drainagebeton (6) zu sorgen.

11. Hybridsystem (1) nach dem vorstehenden Anspruch, wobei die Grundschicht aus Beton (3) eine Druckfestigkeit in 28 Tagen $R_c28$ von mehr als 20 MPa und eine Zugfestigkeit durch Spalten $R_{tb}$ von mehr als 2,5 MPa aufweist.

12. Hybridsystem (1) nach einem der vorstehenden Ansprüche 10 oder 11, wobei die Grundschicht aus Beton (3) selbstverdichtend ist.

13. Hybridsystem (1) nach einem der vorstehenden Ansprüche, wobei der Schnittstellenmörtel (4b) des dritten Teils (7) ein Mörtel ist, der insbesondere das Folgendes beinhaltet:

    - eine Menge an feinem Sand;
    - eine Menge an Zement;
    - eine Menge an Zusatzwasser von 200 und 350 kg/m$^3$,

    um im frischen Zustand eine begrenzte Fließfähigkeit aufzuweisen, um das Abfließen in die Schicht aus Drainagebeton (6) zu verhindern, und mechanische Leistungen, die es ermöglichen, die vom angenommenen Verkehr erzeugten Belastungen aufzunehmen.

14. Hybridsystem (1) nach einem der vorstehenden Ansprüche, wobei die Wärmeträgerflüssigkeit Wasser ist.

15. Einheit (11), umfassend:

    - mehrere Hybridsysteme (1) nach einem der Ansprüche 1 bis 14,
    - Zirkulationsmittel für die Wärmeträgerflüssigkeit in den zweiten Teilen der Hybridsysteme (1),
    - Mittel zum Speichern der Wärmeenergie, die mit den Zirkulationsmitteln gekoppelt sind,
    - Mittel zum Aufnehmen der elektrischen Energie, die mit den Solarpaneelen verbunden sind.

**EP 4 089 912 B1**

16. Einheit (11) nach Anspruch 15, wobei die Einheit (11) Mittel zum Erwärmen der Wärmeträgerflüssigkeit umfasst, die mit den Zirkulationsmitteln für die Wärmeträgerflüssigkeit gekoppelt sind, um die Solarfahrbahn insbesondere zu enteisen.

17. Einheit (11) nach Anspruch 15, wobei die Hybridsysteme (1) in Form von Modulen hergestellt sind, die es ermöglichen, den Raum zu pflastern.

18. Einheit (11) nach Anspruch 17, wobei die Hybridsysteme (1) in Form von hydraulisch und/oder elektrisch miteinander verbindbaren Modulen hergestellt sind.

19. Verfahren zum Herstellen des Hybridsystems (1) nach einem der Ansprüche 1 bis 14, die folgenden Schritte umfassend:

   - Vergießen einer Schicht aus Drainagebeton (6) auf den ersten Teil (2),
   - Vergießen einer Schicht aus Schnittstellenmörtel (4b) auf die ausgehärtete Schicht aus Drainagebeton (6),
   - Verkleben der elektrischen Schicht (8) mit Solarpaneelen (9) auf der Mörtelschicht (4b), und
   - Herstellen der halbtransparenten Oberflächenschicht (10), die sich aus Granulaten aus Glas und Kleber zusammensetzt.

20. Verfahren nach Anspruch 19, wobei das Herstellen der elektrischen Schicht (8) und der halbtransparenten Oberflächenschicht (10) den folgenden Schritten folgt:

   - Vergießen einer Dicke an flüssigem transparentem Kleber, der die Aufgabe eines Bindemittels übernimmt, an der ausgehärteten Schicht aus Schnittstellenmörtel (4b) anliegend,
   - Verkleben der elektrischen Schicht (8) mit Solarpaneelen (9) auf der ausgehärteten Mörtelschicht (4b), durch Polymerisieren des Klebers,
   - Vergießen einer zweiten Dicke an flüssigem transparentem Kleber, und Verlegen der in die zweite Dicke eingelassenen Granulate aus Glas, und
   - Polymerisieren der Einheit,

   zum Herstellen der halbtransparenten Oberflächenschicht (10), die sich aus Granulaten aus Glas und Kleber zusammensetzt.

**Claims**

1. Hybrid system (1) for a solar pavement, wherein the hybrid system (1) has a multilayer sandwich structure with solar panels (9) and a heat exchanger,
   the multilayer sandwich structure being formed by a horizontal stack of layers having:

   > a first part (2) called "lower skin" which is impermeable, capable of ensuring a resistance and a mechanical support of the hybrid system (1);
   > a second part (5) called "core" including a layer of pervious concrete (6), allowing the circulation of a heat transfer liquid capable in particular of recovering thermal energy from the pavement via heat transfer, and of regulating the temperature of the solar panels (9), bearing on the first part (2);
   > a third part (7) called "upper skin" including:

   - an intermediate layer of interface mortar (4b), bearing on the layer of pervious concrete (6);
   - an electric layer (8) composed of solar panels (9) to generate electricity, bearing on the intermediate layer of interface mortar (4b);
   - a semi-transparent surface layer (10) including glass aggregates and a transparent glue acting as a binder, bearing on the electric layer (8); the semi-transparent surface layer (10) having a resistance to compressive stress greater than or equal to 1MPa,

   > the second part (5) and the third part (7) forming the heat exchanger, the third part (7) storing the heat that is exchanged with the heat transfer liquid circulating only in the second part (5).

2. Hybrid system (1) according to claim 1, wherein the second part (5) and the third part (7) are configured to increase the energy efficiency of the heat exchanger by:

- a greenhouse effect linked to the semi-transparent surface layer (10), and
- the coefficient of convection between the layer of pervious concrete (6) and the heat transfer liquid, and
- the permeability of the layer of pervious concrete (6).

3. Hybrid system (1) according to one of the preceding claims, wherein the layer of pervious concrete (6) has a permeability K greater than 2cm/s and a resistance to compressive stress at 28 days $R_c28$ greater than 2MPa.

4. Hybrid system (1) according to one of the preceding claims, wherein the layer of pervious concrete (6) has a permeability K greater than 4cm/s and a resistance to compressive stress at 28 days $R_c28$ greater than 2MPa.

5. Hybrid system (1) according to one of the preceding claims, wherein in the layer of pervious concrete (6), the maximum diameter of aggregates does not exceed 20% of the thickness of the layer of pervious concrete (6).

6. Hybrid system (1) according to one of the preceding claims, wherein the layer of pervious concrete (6) consists:

- of a quantity of crushed stone d/D between 1000 and 1500kg/m$^3$; advantageously between 1100 and 1300kg/m$^3$;
- of a quantity of cement with fines, between 200 and 500kg/m$^3$; advantageously between 300 and 400kg/m$^3$;
- of a quantity of added water between 50 and 150kg/m$^3$.

7. Hybrid system (1) according to one of the preceding claims, wherein the layer of pervious concrete (6) has superplasticisers.

8. Hybrid system (1) according to one of the preceding claims, wherein the intermediate layer of interface mortar (4b) is a cementitious material.

9. Hybrid system (1) according to the preceding claim, wherein the intermediate layer of interface mortar (4b) has the following characteristics:

-

$$D_{max} < 4mm$$

-

$$R_c28 > 40MPa.$$

10. Hybrid system (1) according to one of the preceding claims, wherein the first part (2) includes a base layer made of concrete (3), on which an intermediate layer of interface mortar (4a) intended to provide the sealing with the layer of pervious concrete (6) rests.

11. Hybrid system (1) according to the preceding claim, wherein the base layer made of concrete (3) has a compressive strength at 28 days $R_c28$ greater than 20MPa and a splitting tensile strength $R_{tb}$ greater than 2.5MPa.

12. Hybrid system (1) according to one of the preceding claims 10 or 11, wherein the base layer made of concrete (3) is self-consolidating.

13. Hybrid system (1) according to one of the preceding claims, wherein the interface mortar (4b) of the third part (7) is a mortar including in particular:

- a quantity of fine sand;
- a quantity of cement;
- a quantity of added water between 200 to 350kg/m$^3$,

so as to have a limited fluidity in the fresh state avoiding flow into the layer of pervious concrete (6), and a mechanical performance allowing to absorb the stresses generated by the traffic considered.

14. Hybrid system (1) according to one of the preceding claims, wherein the heat transfer liquid is water.

15. Assembly (11) comprising:

    - several hybrid systems (1) according to one of claims 1 to 14,
    - means for circulating the heat transfer liquid in the second parts of the hybrid systems (1),
    - means for storing the thermal energy coupled to the circulation means,
    - means for recovering the electric energy, connected to the solar panels.

16. Assembly (11) according to claim 15, wherein the assembly (11) comprises means for heating the heat transfer liquid coupled to the means for circulating the heat transfer liquid in order to in particular de-ice the solar pavement.

17. Assembly (11) according to claim 15, wherein the hybrid systems (1) are made in the form of modules allowing to pave the space.

18. Assembly (11) according to claim 17, wherein the hybrid systems (1) are made in the form of hydraulically and/or electrically interconnectable modules.

19. Method for producing the hybrid system (1) defined according to one of claims 1 to 14, comprising the following steps:

    - pouring a layer of pervious concrete (6) onto the first part (2),
    - pouring a layer of interface mortar (4b) onto the hardened layer of pervious concrete (6),
    - gluing the electric layer (8) with solar panels (9) onto the layer of mortar (4b), and
    - creating the semi-transparent surface layer (10) consisting of glass aggregates and glue.

20. Method according to claim 19, wherein the creation of the electric layer (8) and of the semi-transparent surface layer (10) follows the following steps:

    - pouring a thickness of liquid transparent glue acting as a binder, bearing on the hardened layer of interface mortar (4b),
    - gluing the electric layer (8) with solar panels (9) onto the hardened layer of mortar (4b), by polymerisation of the glue,
    - pouring a second thickness of liquid transparent glue, and placing the glass aggregates set in the second thickness, and
    - polymerisation of the whole,

to create the semi-transparent surface layer (10) consisting of glass aggregates and glue.

Figure 1

Figure 2

**Epaisseurs en mm**

Cumulées    Indiv.

135      10

125      5
120      75

45      0
45      45

0      0 mm

## Figure 3

19 cm      Dalles béton

3 cm      Lit de pose 2/4

Grave-ciment excavable

2*20 cm

Plate-forme (PF2)

## Figure 4

11

Figure 5

Figure 6

Figure 7

Figure 8

10 mm

Surface semi-transparente
Cellules photovoltaïques    9
Mortier 4b
Béton poreux 6
Mortier 4a
B.A.P. 3

135    70    10    5    45

# Figure 9

10 mm

Surface semi-transparente
Cellules photovoltaïques
Étanchéité d'ouvrages d'art
Enrobé bitumineux drainant
Étanchéité d'ouvrages d'art
E. M. E. (Enrobé Module Élevé

140    75    15    2.5    45

# Figure 10

Figure 11

Figure 12

Figure 13

Figure 14

Figure 15

Figure 16

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4132074 A
- WO 0210654 A
- US 20050199282 A
- WO 2014125415 A

**Littérature non-brevet citée dans la description**

- Thermal and electrical performance of a novel photovoltaic-thermal road. **XIANG BO et al.** SOLAR ENERGY. ELSEVIER, 09 Février 2020, vol. 199, 1-18